# EUROPEAN PATENT SPECIFICATION

(11) **EP 2 586 809 B1**
(45) Date of publication and mention of the grant of the patent: **10.08.2016**
(21) Application number: 10853438.9
(22) Date of filing: 23.06.2010
(51) Int. Cl.: C08G 61/12, H01L 51/00, C09K 11/00

(54) **POLYMER CONTAINING UNITS OF FLUORENE, ANTHRACENE AND BENZOTHIADIAZOLE, PREPARATION METHOD AND USES THEREOF**
POLYMER MIT FLUOREN-, ANTRHACEN- UND BENZOTHIADIAZOLEINHEITEN, HERSTELLUNGSVERFAHREN UND VERWENDUNG
POLYMÈRE CONTENANT DES UNITÉS DE FLUORÈNE, D'ANTHRACÈNE ET DE BENZOTHIADIAZOLE, SON PROCÉDÉ DE PRÉPARATION ET SON UTILISATION

(43) Date of publication of application: 01.05.2013
(73) Proprietor: Ocean's King Lighting Science&Technology Co., Ltd., Guangdong 518054 (CN)
(72) Inventor: ZHOU, Mingjie, Shenzhen, Guangdong 518054 (CN); HUANG, Jie, Shenzhen, Guangdong 518054 (CN); HUANG, Jiale, Shenzhen, Guangdong 518054 (CN)
(74) Representative: Michalski Hüttermann & Partner Patentanwälte mbB
(86) International application number: PCT/CN2010/074320
(87) International publication number: WO 2011/160295

(56) References cited:
- EP-A1- 2 072 557
- EP-A1- 2 110 400
- WO-A1-03/007395
- WO-A1-2009/125647
- CN-A- 1 337 987
- CN-A- 101 481 455
- US-A1- 2003 066 950
- US-A1- 2003 186 079
- US-A1- 2010 032 018
- YANG C ET AL: "Polyphenylenes and poly(phenyleneethynylene)s with 9,10-anthrylene subunits", MACROMOLECULAR CHEMISTRY AND PHYSICS, vol. 207, no. 13, 5 July 2006 (2006-07-05) , pages 1107-1115, XP002718207, WILEY-VCH VERLAG DE DOI: 10.1002/MACP.200600142
- JAE-KYU JIN ET AL: "Synthesis and Photovoltaic Performance of Low-Bandgap Polymers on the Basis of 9,9-Dialkyl-3,6-dialkyloxysilafluorene", MACROMOLECULES, vol. 44, no. 3, 8 February 2011 (2011-02-08), pages 502-511, XP055094370, ISSN: 0024-9297, DOI: 10.1021/ma102173a
- GIOVANELLA U ET AL: "Core-type polyfluorene-based copolymers for low-cost light-emitting technologies", ORGANIC ELECTRONICS, vol. 11, no. 12, 1 December 2010 (2010-12-01), pages 2012-2018, XP027484567, ELSEVIER, AMSTERDAM, NL ISSN: 1566-1199, DOI: 10.1016/J.ORGEL.2010.09.009 [retrieved on 2010-09-23]
- HYUN-TAE PARK ET AL: "Color Pure and Stable Blue Light Emitting Material Containing Anthracene and Fluorene for OLED", BULLETIN OF THE KOREAN CHEMICAL SOCIETY, vol. 31, no. 7, 20 July 2010 (2010-07-20), pages 1951-1955, XP055094368, ISSN: 0253-2964, DOI: 10.5012/bkcs.2010.31.7.1951
- LI W ET AL: "Tailoring side chains of low band gap polymers for high efficiency polymer solar cells", POLYMER, vol. 51, no. 14, 24 June 2010 (2010-06-24) , pages 3031-3038, XP027089683, ELSEVIER SCIENCE PUBLISHERS B.V, GB ISSN: 0032-3861 [retrieved on 2010-05-15]
- KIM J ET AL: "Low-bandgap poly(4H-cyclopenta[def]phenanthrene) derivatives with 4,7-dithienyl-2,1,3-benzothiadiazole unit for photovoltaic cells", POLYMER, vol. 51, no. 2, 21 January 2010 (2010-01-21), pages 390-396, XP026855030, ELSEVIER SCIENCE PUBLISHERS B.V, GB ISSN: 0032-3861 [retrieved on 2009-12-16]
- DMITRIJ BONDAREV ET AL: "New fluorene-based copolymers containing oxadiazole pendant groups: Synthesis, characterization, and polymer stability", JOURNAL OF POLYMER SCIENCE PART A: POLYMER CHEMISTRY, vol. 47, no. 18, 15 September 2009 (2009-09-15), pages 4532-4546, XP055025422, ISSN: 0887-624X, DOI: 10.1002/pola.23506
- JIN SU PARK ET AL: "Synthesis and characterization of fluorene-based low-band gap copolymers containing propylenedioxythiophene and benzothiadiazole derivatives for bulk heterojunction photovoltaic cell applications", JOURNAL OF POLYMER SCIENCE PART A: POLYMER CHEMISTRY, vol. 46, no. 18, 15 September 2008 (2008-09-15), pages 6175-6184, XP008142350, JOHN WILEY & SONS, INC, UNITED STATES ISSN: 0887-624X, DOI: 10.1002/POLA.22928 [retrieved on 2008-08-12]
- SUN J ET AL: "pi-Conjugated poly(anthracene-alt-fluorene)s with X-shaped repeating units: New blue-light emitting polymers", POLYMER, vol. 49, no. 9, 29 April 2008 (2008-04-29) , pages 2282-2287, XP022618183, ELSEVIER SCIENCE PUBLISHERS B.V, GB ISSN: 0032-3861, DOI: 10.1016/J.POLYMER.2008.03.006 [retrieved on 2008-03-07]
- WEN-YA LEE ET AL: "Effects of Acceptors on the Electronic and Optoelectronic Properties of Fluorene-Based Donor Acceptor Donor Copolymers", MACROMOLECULAR CHEMISTRY AND PHYSICS, vol. 208, no. 17, 2 August 2007 (2007-08-02), pages 1919-1927, XP008148723, WILEY-VCH VERLAG, WEINHEIM, DE ISSN: 1022-1352, DOI: 10.1002/MACP.200700158
- ADMASSIE S ET AL: "Electrochemical and optical studies of the band gaps of alternating polyfluorene copolymers", SYNTHETIC METALS, vol. 156, no. 7-8, 5 April 2006 (2006-04-05), pages 614-623, XP027940285, ELSEVIER SEQUOIA, LAUSANNE, CH ISSN: 0379-6779 [retrieved on 2006-04-05]
- SVENSSON M ET AL: "High-Performance Polymer Solar Cells of an Alternating Polyfluorene Copolymer and a Fullerene Derivative", ADVANCED MATERIALS, vol. 15, no. 12, 17 June 2003 (2003-06-17) , pages 988-991, XP008142352, WILEY VCH VERLAG, DE ISSN: 0935-9648, DOI: 10.1002/ADMA.200304150 [retrieved on 2003-06-16]
- CHU-YING CHUANG ET AL: "Bright-White Light-Emitting Devices Based on a Single Polymer Exhibiting Simultaneous Blue, Green, and Red Emissions", MACROMOLECULES, vol. 40, no. 2, 23 January 2007 (2007-01-23), pages 247-252, XP008147627, AMERICAN CHEMICAL SOCIETY, WASHINGTON, DC; US ISSN: 0024-9297, DOI: 10.1021/MA062192+ [retrieved on 2006-12-30]
- CHENJUN SHI ET AL: "Regioregular Copolymers of 3-Alkoxythiophene and Their Photovoltaic Application", JOURNAL OF THE AMERICAN CHEMICAL SOCIETY, vol. 128, no. 27, 12 July 2006 (2006-07-12), pages 8980-8986, XP002658684, ACS PUBLICATIONS, US ISSN: 0002-7863, DOI: 10.1021/JA061664X [retrieved on 2006-06-14]
- KIM Y-H ET AL: "NOVEL BLUE EMITTING MATERIAL WITH HIGH COLOR PURITY", ADVANCED MATERIALS, vol. 13, no. 22, 16 November 2001 (2001-11-16), pages 1690-1693, XP001130222, WILEY VCH VERLAG, DE ISSN: 0935-9648, DOI: 10.1002/1521-4095(200111)13:22<1690::AID-A DMA1690>3.0.CO;2-K
- SVENSSON M ET AL: "Synthesis and properties of alternating polyfluorene copolymers with redshifted absorption for use in solar cells", SYNTHETIC METALS, vol. 135-136, 1 January 2003 (2003-01-01), pages 137-138, XP002300443, ELSEVIER SEQUOIA, LAUSANNE, CH ISSN: 0379-6779, DOI: 10.1016/S0379-6779(02)00552-0
- BUNDGAARD ET AL: "Bulk heterojunctions based on a low band gap copolymer of thiophene and benzothiadiazole", SOLAR ENERGY MATERIALS AND SOLAR CELLS, vol. 91, no. 17, 17 August 2007 (2007-08-17), pages 1631-1637, XP022206199, ELSEVIER SCIENCE PUBLISHERS, AMSTERDAM, NL ISSN: 0927-0248, DOI: 10.1016/J.SOLMAT.2007.05.013

## Description

### FIELD OF THE INVENTION

The present disclosure relates to optoelectronic technology, and more particularly relates to a polymer containing units of fluorene, anthracene and benzothiadiazole, preparation method thereof and application thereof.

### BACKGROUND OF THE INVENTION

The raw material of the traditional solar cell device with high-efficiency is mainly inorganic semiconductor silicon. However, the complex of the production process, serious pollution, energy consumption, high cost of the silicon solar cells inhibit the development of its commercial applications.

US 2010/032018 A1 refers to photoactive polymers, as well as related components, articles, systems, and methods thereof.

WO 2009/125647 A1 refers to an electron donating organic material that can provide a photovoltaic element with a high photoelectric conversion efficiency. The electron donating organic material comprises a benzothiadiazole compound satisfying requirements that (a) a benzothiadiazole skeleton and an oligothiophene skeleton are contained, (b) the bandgap (Eg) is not more than 1.8 eV, and (c) the level of the highest occupied molecular orbital (HOMO) is not more than -4.8 eV. In the benzothiadiazole compound, the benzothiadiazole skeleton and the oligothiophene skeleton are alternately covalently bonded.

EP 2 072 557 A1 refers to a a photovoltaic device with high photoelectric conversion efficiency, an electron donating organic material for photovoltaic devices containing a conjugated polymer.

WO 03/007395 A1 refers to a organic block polymer useful in an electroluminescent polymer device, comprising: (a) an emissive polymer block that is consistently conjugated along the backbone of the emissive polymer block; and at least two of the following: (b) a positive charge carrier polymer block that is consistently conjugated along the backbone of the positive charge carrier polymer block for transporting positive charge carriers to the emissive polymer block so that the positive charge carriers can combine with negative charge carriers to generate light (c) a negative charge carrier polymer block that is consistently conjugated along the backbone of the negative charge carrier polymer block for transporting negative charge carriers to the emissive polymer block so that the negative charge carriers can combine with positive charge carriers to generate light, and (d) a host polymer block that is consistently conjugated along the backbone of the host block for providing a matrix for emitter that affords Forster energy transfer and inhibition of concentration quenching effects.

EP 2 110 400 A1 refers to a a block copolymer characterized by containing a block (A) containing two or more different repeating units respectively composed of a specific divalent heterocyclic group, and a repeating unit composed of an arylene group, and a block (B) containing a repeating unit composed of an arylene group and a repeating unit composed of a divalent aromatic amine residue. Also disclosed are a composition containing a solvent, a light-emitting material other than the block copolymer, a hole-transporting material other than the block copolymer, an electron-transporting material other than the block copolymer or a combination of two or more of them, in addition to the block copolymer; a light-emitting thin film characterized by containing the block copolymer; and a polymer light-emitting device characterized by having an anode, a cathode and an organic layer containing the block copolymer and arranged between the anode and the cathode.

US 2003/186079 A1 refers to an electroluminescent device comprising: an anode electrode layer; a layer comprising doped PEDOT over the anode electrode layer; a semiconducting region over the anode electrode layer, the semiconducting region comprising a first semiconducting organic layer comprising a first semiconducting organic component adjacent to a second semiconducting organic layer comprising a second semiconducting organic component, the first semiconducting layer being disposed between the layer of doped PEDOT and the second semiconducting layer; and a cathode electrode layer over the semiconducting region, wherein the first semiconducting organic layer is capable of hole transport and wherein the second semiconducting organic layer is light emissive.

Non patent literature in the field of fluorene, anthracene and benzothiadiazole compounds are mentioned below.

YANG C ET AL: "Polyphenylenes and poly(phenyleneethynylene)s with 9,10-anthrylene subunits", MACROMOLECULAR CHEMISTRYAND PHYSICS, vol. 207, no. 13, 5 July 2006 (2006-07-05), pages 1107-111 5, XP002718207, WILEY-VCH VERLAG DE.

JAE-KYU JIN ET AL: "Synthesis and Photovoltaic Performance of Low-Bandgap Polymers on the Basis of 9,9-Dialkyl-3,6-dialkyloxysilafluorene", MACROMOLECULES, vol. 44, no. 3, 8 February 2011 (2011 -02-08), pages 502-511, XP055094370.

GIOVANELLA U ET AL: "Core-type polyfluorene-based copolymers for low-cost light-emitting technologies", ORGANIC ELECTRONICS, vol. 11, no. 12, 1 December 2010 (2010-12-01), pages 201 2-2018, XP027484567, ELSEVIER, AMSTERDAM, NL.

HYUN-TAE PARK ET AL: "Color Pure and Stable Blue Light Emitting Material Containing Anthracene and Fluorene for OLED", BULLETIN OF THE KOREAN CHEMICAL SOCIETY, vol. 31, no. 7, 20 July 2010 (201 0-07-20), pages 1951-1955, XP055094368.

Ll W ET AL: "Tailoring side chains of low band gap polymers for high efficiency polymer solar cells", POLYMER, vol. 51, no. 14, 24 June 2010 (2010-06-24), pages 3031-3038, XP027089683, ELSEVIER SCIENCE PUBLISHERS B.V, GB.

KIM J ET AL: "Low-bandgap poly(4H-cyclopenta[def]phenanthrene) derivatives with 4,7-dithienyl-2,1,3-benzothiadiazole unit for photovoltaic cells", POLYMER, vol. 51, no. 2, 21 January 2010 (2010-01 -21), pages 390-396, XP026855030, ELSEVIER SCIENCE PUBLISHERS B.V, GB

DMITRIJ BONDAREV ET AL: "New fluorene-based copolymers containing oxadiazole pendant groups: Synthesis, characterization, and polymer stability", JOURNAL OF POLYMER SCIENCE PART A: POLYMER CHEMISTRY, vol. 47, no. 18, 15 September 2009 (2009-09-15), pages 4532-4546, XP055025422.

JIN SU PARK ET AL: "Synthesis and characterization of fluorene-based low-band gap copolymers containing propylenedioxythiophene and benzothiadiazole derivatives for bulk heterojunction photovoltaic cell applications", JOURNAL OF POLYMER SCIENCE PART A: POLYMER CHEMISTRY, vol. 46, no. 18, 15 September 2008 (2008-09-15), pages 6175-6184, XP008142350.

SUN J ET AL: "pi-Conjugated poly(anthracene-alt-fluorene)s with X-shaped repeating units: New blue-light emitting polymers", POLYMER, vol. 49, no. 9, 29 April 2008 (2008-04-29), pages 2282-2287, XP022618183.

WEN-YA LEE ET AL: "Effects of Acceptors on the Electronic and Optoelectronic Properties of Fluorene-Based Donor Acceptor Donor Copolymers", MACROMOLECULAR CHEMISTRYAND PHYSICS, vol. 208, no. 17, 2 August 2007 (2007-08-02), pages 1919-1927, XP008148723, WILEY-VCH VERLAG, WEINHEIM, DE.

ADMASSIE S ET AL: "Electrochemical and optical studies of the band gaps of alternating polyfluorene copolymers", SYNTHETIC METALS, vol. 156, no. 7-8, 5 April 2006 (2006-04-05), pages 614-623, XP027940285, ELSEVIER SEQUOIA, LAUSANNE, CH.

SVENSSON M ET AL: "High-Performance Polymer Solar Cells of an Alternating Polyfluorene Copolymer and a Fullerene Derivative", ADVANCED MATERIALS, vol. 15, no. 12, 17 June 2003 (2003-06-17), pages 988-991, XP008142352, WILEYVCH VERLAG, DE.

CHU-YING CHUANG ET AL: "Bright-White Light-Emitting Devices Based on a Single Polymer Exhibiting Simultaneous Blue, Green, and Red Emissions", MACROMOLECULES, vol. 40, no. 2, 23 January 2007 (2007-01-23), pages 247-252, XP008147627, AMERICAN CHEMICALSOCIETY, WASHINGTON, DC; US.

CHENJUN SHI ET AL: "Regioregular Copolymers of 3-Alkoxythiophene and Their Photovoltaic Application", JOURNAL OF THE AMERICAN CHEMICAL SOCIETY, vol. 128, no. 27, 12 July 2006 (2006-07-12), pages 8980-8986, XP002658684, ACS PUBLICATIONS, US.

KIM Y-H ET AL: "NOVEL BLUE EMITTING MATERIAL WITH HIGH COLOR PURITY", ADVANCED MATERIALS, vol. 13, no. 22, 16 November 2001 (2001 -11 -16), pages 1690-1693, XP001130222, WILEY VCH VERLAG, DE.

SVENSSON M ET AL: "Synthesis and properties of alternating polyfluorene copolymers with redshifted absorption for use in solar cells", SYNTHETIC METALS, vol. 135-136, 1 January2003 (2003-01-01), pages 137-138, XP002300443, ELSEVIER SEQUOIA, LAUSANNE, CH.

BUNDGAARD ET AL: "Bulk heterojunctions based on a low band gap copolymer of thiophene and benzothiadiazole", SOLAR ENERGY MATERIALS AND SOLAR CELLS, vol. 91, no. 17, 17 August 2007 (2007-08-17), pages 1631-1 637, XP022206199, ELSEVIER SCIENCE PUBLISHERS, AMSTERDAM, NL.

The preparation of low-cost and high-energy solar cells by using cheap materials has been a research hotspot and difficulty in the photovoltaic field. On one hand, because the organic materials have good environment stability, low production cost, regulation function easily, flexibility and good film forming properties; on the other hand, because the preparation process of organic solar cell is relatively simple, low operation temperature, low device fabrication cost. The organic semiconductor material has attracted much attention and has become the solar cell materials with low cost and attractive. In addition, the organic solar cell has some advantages such as it can be prepared in large areas and use flexible substrates, and it is environmentally friendly and portable.

Organic photovoltaic material has the following advantages: good thermal stability, processing easily, low cost and specific optoelectronic functions can be achieved by molecular design. Anthracene and its derivatives have good stability and good film-forming properties; their UV-visible spectroscopy show wide finger peak absorption, which is conducive to improve the absorption of sunlight; in addition, anthracene and its derivatives have appropriate carrier transport characteristics, and the hole mobility of the crystal at room temperature can reach to 3cm²/V · s, anthracene and its derivatives are excellent organic semiconductor materials. Although there are many reports about anthracene and its derivatives as organic electroluminescent materials, but anthracene and its derivatives as an organic photovoltaic material have rarely been reported, which greatly limit the scope of their application.

### SUMMARY OF THE INVENTION

In one aspect of the present disclosure, an organic photovoltaics compounds containing anthracene unit is desired.

In addition, in another aspect of the present disclosure, a preparation method and application of the organic photovoltaics compounds containing anthracene unit is also desired.

A polymer containing units of fluorene, anthracene and benzothiadiazole has the following formula: 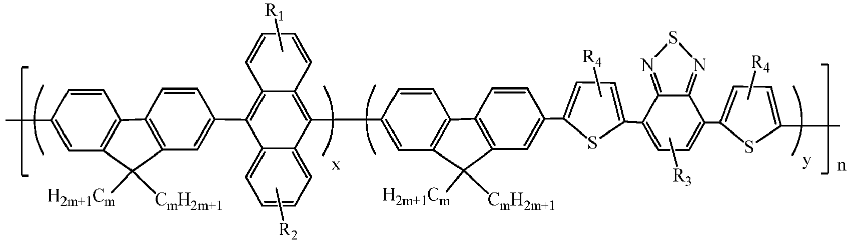 wherein n represents an integer between 1 and 200, m represents an integer between 1 and 20; x, y are positive real numbers, and x + y = 1; R₁, R₂ represent H, halogen, cyano, C₁ to C₄₀ alkyl, C₁ to C₄₀ aryl or C₁ to C₄₀ heteroaryl; R₃, R₄ represent H, halogen, cyano, C₁ to C₄₀ alkyl, C₁ to C₄₀ alkoxy, C₆ to C₄₀ aryl, C₆ to C₄₀ aralkyl or C₆ to C₄₀ arylalkoxy.

R₁, R₂, R₃, R₄ described above can represent mono-substituted functional group or multi-substituted functional group, for example, R₁ can represent two substituents, three substituents, and so on.

A preparation method of a polymer containing units of fluorene, anthracene and benzothiadiazole, includes the following steps:
S11, compounds A, B and C represented by the following formulas are provided, respectively, 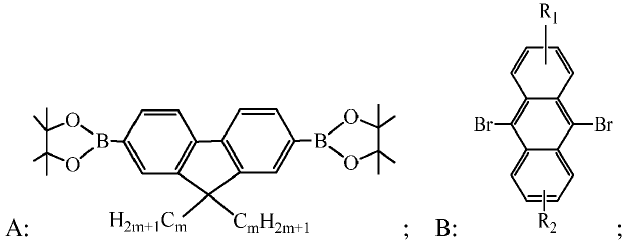 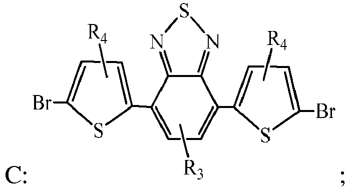 wherein m represents an integer between 1 and 20;
S12, under the condition of oxygen-free environment, compounds A, B and C are subjected to a Suzuki coupling reaction in the presence of organic solvent, catalyst and alkaline solution to obtain the polymer containing units of fluorene, anthracene and benzothiadiazole with the following formula: 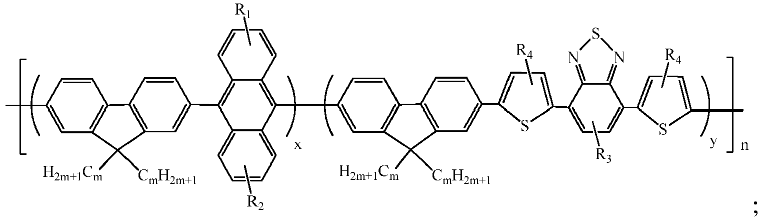
   wherein n represents an integer between 1 and 200; m represents an integer between 1 and 20;
   x, y are positive real numbers, and x + y = 1;
   R₁, R₂ represent H, halogen, cyano, C₁ to C₄₀ alkyl, C₁ to C₄₀ aryl or C₁ to C₄₀ heteroaryl;
   R₃, R₄ represent H, halogen, cyano, C₁ to C₄₀ alkyl, C₁ to C₄₀ alkoxy, C₆ to C₄₀ aryl, C₆ to C₄₀ aralkyl or C₆ to C₄₀ arylalkoxy.

Preferably, in step S1, compound A is prepared by the following steps: compounds D and E represented by the following formulas are provided, respectively, 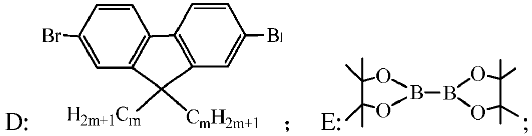 wherein m represents an integer between 1 and 20;
under conditions of anhydrous and oxygen-free environment, compound D is added to the solvent at a temperature of -70 °C to -85 °C , n-butyl lithium is added to solution according to a molar ratio of the n-butyl lithium to the compound D of 2:1 to 4:1, and then the solution is stirred for 2 hours; the solvent is at least one selected from the group consisting of tetrahydrofuran, diethyl ether, dichloromethane, chloroform, and ethyl acetate;
compound E is added to the solution according to a molar ratio of the compound E to the compound D of 2:1 to 4:1, the temperature is raised to room temperature, after the reaction lasted for 12 to 48 hours, the compound A represented by the following formula is obtained: 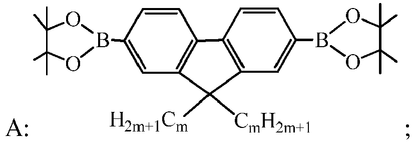 wherein m represents an integer between 1 and 20.

Preferably, in step S12, the solvent is at least one selected from the group consisting of toluene, ethylene glycol, dimethyl ether, tetrahydrofuran, diethyl ether, dichloromethane, chloroform and ethyl acetate; the added amount of alkali solution is 5 to 10 times of a molar amount of the compound A; the added amount of catalyst is 0.5% to 10% of a molar amount of compound A; the catalyst is organic palladium catalyst or a mixture of organic palladium and organic phosphine ligand; the alkali solution is NaOH aqueous solution, Na₂CO₃ aqueous solution, NaHCO₃ aqueous solution or tetraethyl ammonium hydroxide aqueous solution, the temperature of the Suzuki coupling reaction is 60 to 100 °C, the reaction time is 12 to 72 hours.

Preferably, a molar ratio of the organic palladium to the organic phosphine ligand is 1:2 to 1:20 in the mixture of organic palladium and organic phosphine ligand; the organic palladium is Pd₂(dba)₃, Pd(PPh₃)₄ or Pd(PPh₃)₂Cl₂; the organic phosphine ligand is P(o-Tol)₃.

Preferably, the preparation method further includes the purification process after the polymer is obtained, the purification steps comprise:
S 13, the deionized water and toluene are added to the polymer obtained in step S12 to extract the polymer, the organic phase is extracted and distilled under reduced pressure, and then add the organic phase dropwise to the anhydrous methanol with stirring constantly, and then the solid is precipitated from the solution, the solid is pumping filtrated and dried to obtain the solid powder, and then the solid powder is dissolved in chloroform and purified by column chromatography of neutral alumina, after the catalyst is removed, the solution was rotary evaporated, and then add the solution dropwise to the methanol solvent with stirring, finally the solution is extracted by Soxhlet extraction to obtain a purified polymer.

A solar cell device using the polymer described above includes a substrate, a conductive layer deposited on one surface of the substrate serving as an anode, a poly 3, 4 - ethylenedioxy thiophene: polystyrene sulfonic acid layer coated on the conductive layer functioning for modification; an active layer coated on the surface of the poly 3, 4 - ethylenedioxy thiophene: polystyrene sulfonic acid layer, and an aluminum layer coated on the active layer serving as a cathode; the material of the active layer is mixture which includes electron donor materials and electron acceptor materials; the electron acceptor material is [6, 6] - phenyl - C61 - butyric acid methyl ester, the electron donor material includes the polymer containing units of fluorene, anthracene and benzothiadiazole described above.

An organic light-emitting device using the polymer described above includes a substrate, a conductive layer deposited on one surface of the substrate serving as an anode, a luminescent layer coated on the conductive layer, a buffer layer deposited on the surface of the luminescent layer, and an aluminum layer coated on the buffer layer serving as a cathode, the buffer layer is deposited by evaporation and the material of the buffer layer is LiF, the material of the luminescent layer includes the polymer containing units of fluorene, anthracene and benzothiadiazole described above.

An organic field-effect transistor using the polymer described above includes a doping silicon wafer, a SiO₂ insulation layer, an octadecyltrichlorosilane layer for modifying the SiO₂ insulation layer, an organic semiconductor layer coated on the octadecyltrichlorosilane layer, a source electrode and a drain electrode interval disposed on the organic semiconductor layer, which are laminated in this order, the material of the organic semiconductor layer includes the polymer containing units of fluorene, anthracene and benzothiadiazole described above.

Anthracene and its derivatives have good stability and good film-forming properties; their UV-visible spectroscopy shows wide finger peak absorption, which is contributive to improve the absorption of sunlight, in addition, anthracene and its derivatives have appropriate carrier transport characteristics, and the hole mobility of the crystal at room temperature can reach to 3cm²/V · s, thus making them a kind of excellent organic semiconductor materials. The compound containing fluorene has the structure which can be modified easily, and the compound containing fluorene has a good light and heat stability and film forming properties.

The polymer containing units of fluorene, anthracene and benzothiadiazole has a low energy gap, high mobility, and a wide absorption range of the spectrum, in addition, the carriers within the active layer material can transmit more efficiently due to the polymer.

### BRIEF DESCRIPTION OF THE DRAWINGS

FIG. 1 is a schematic view of a solar cell device according to an embodiment;
FIG. 2 a schematic view of an organic electroluminescent device according to an embodiment;
FIG. 3 a schematic view of an organic field-effect transistor according to an embodiment.

### DETAILED DESCRIPTION

The objective of the present invention is to provide a polymer containing units of fluorene, anthracene and benzothiadiazole and its preparation method, and to disclose the application of the polymer material in the photoelectric field.

A polymer containing units of fluorene, anthracene and benzothiadiazole has the following formula: 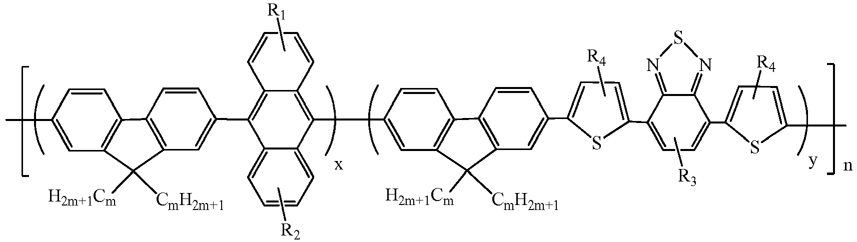 wherein n represents an integer between 1 and 200, m represents an integer between 1 and 20; x, y are positive real numbers, and x + y = 1; R₁, R₂ represent H, halogen, cyano, C₁ to C₄₀ alkyl, C₁ to C₄₀ aryl or C₁ to C₄₀ heteroaryl; R₃, R₄ represent H, halogen, cyano, C₁ to C₄₀ alkyl, C₁ to C₄₀ alkoxy, C₆ to C₄₀ aryl, C₆ to C₄₀ aralkyl or C₆ to C₄₀ arylalkoxy.

R₁, R₂, R₃, R₄ described above can represent mono-substituted functional group or multi-substituted functional group, for example, R₁ can represent two substituents, three substituents, and so on.

A preparation method of a polymer containing units of fluorene, anthracene and benzothiadiazole, includes the following steps:

### Step one

Compounds D and E represented by the following formulas are provided, respectively: 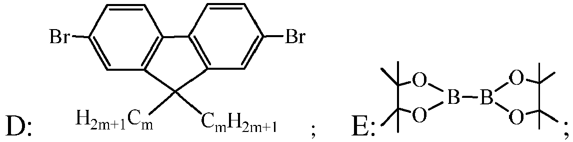 wherein m represents an integer between 1 and 20;
under a temperature of -70 °C to -85 °C, under conditions of anhydrous and oxygen-free environment, the compound D is added to the solvent, the n-butyl lithium is added according to a molar ratio of the n-butyl lithium to the compound D of 2:1 to 4:1, the solution is stirred for 2 hours; the solvent is at least one selected from the group consisting of tetrahydrofuran, diethyl ether, dichloromethane, chloroform, and ethyl acetate;
the compound E is added to the solution according to a molar ratio of the compound E to the compound D of 2:1 to 4:1, the temperature is raised to room temperature, after the reaction lasted for 12 to 48 hours, the compound A represented by the following formula is obtained: 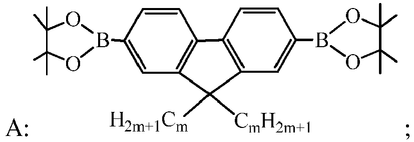 wherein m represents an integer between 1 and 20.

### Step two

Compounds A, B and C represented by the following formulas are provided, respectively, 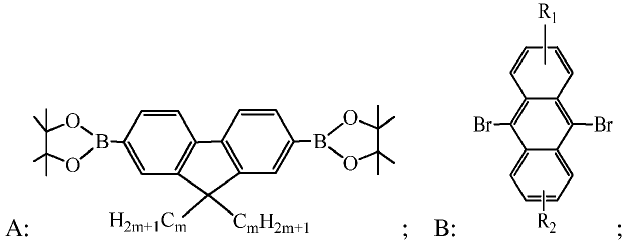 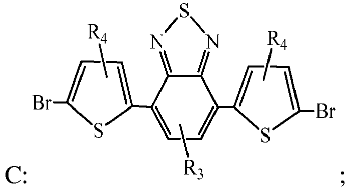 wherein m represents an integer between 1 and 20; under the oxygen-free environment, compounds A, B and C are subjected to a Suzuki coupling reaction in the presence of organic solvent, catalyst and alkaline solution to obtain the polymer containing units of fluorene, anthracene and benzothiadiazole with the following formula: 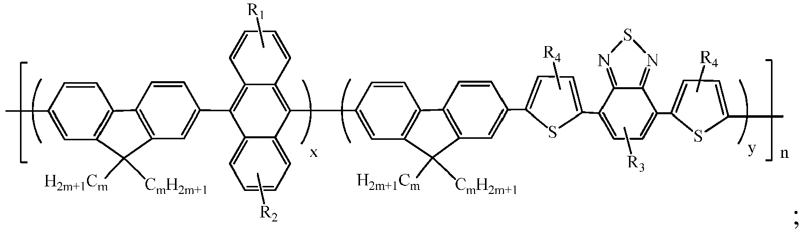
wherein n represents an integer between 1 and 200; m represents an integer between 1 and 20;
x, y are positive real numbers, and x + y = 1;
R₁, R₂ represent H, halogen, cyano, C₁ to C₄₀ alkyl, C₁ to C₄₀ aryl or C₁ to C₄₀ heteroaryl;
R₃, R₄ represent H, halogen, cyano, C₁ to C₄₀ alkyl, C₁ to C₄₀ alkoxy, C₆ to C₄₀ aryl, C₆ to C₄₀ aralkyl or C₆ to C₄₀ arylalkoxy.

R₁, R₂, R₃, R₄ described above can represent mono-substituted functional group or multi-substituted functional group, for example, R₁ can represent two substituents, three substituents, and so on.

Preferably, in step two, the solvent is at least one selected from the group consisting of toluene, ethylene glycol, dimethyl ether, tetrahydrofuran, diethyl ether, dichloromethane, chloroform and ethyl acetate; the added amount of catalyst is 0.5% to 10% of a molar amount of compound A; the catalyst is organic palladium catalyst or a mixture of organic palladium and organic phosphine ligand; the added amount of alkali solution is 5 to 10 times of a molar amount of the compound A; the alkali solution is NaOH aqueous solution, Na₂CO₃ aqueous solution, NaHCO₃ aqueous solution or tetraethyl ammonium hydroxide aqueous solution; the temperature of the Suzuki coupling reaction is 60 to 100 °C, the reaction time is 12 to 72 hours.

Preferably, a molar ratio of the organic palladium to the organic phosphine ligand is 1:2 to 1:20 in the mixture of organic palladium and organic phosphine ligand; the organic palladium is Pd₂(dba)₃, Pd(PPh₃)₄ or Pd(PPh₃)₂Cl₂; the organic phosphine ligand is P(o-Tol)₃.

In a specific embodiment, the oxygen-free condition described above can be achieved by means of nitrogen or inert gas protection.

Step three The deionized water and toluene are added to the polymer obtained to extract the polymer, the organic phase is extracted and distilled under reduced pressure, and then add the organic phase dropwise to the anhydrous methanol with stirring constantly, and then the solid is precipitated from the solution, the solid is pumping filtrated and dried to obtain the solid powder, and then the solid powder is dissolved in chloroform and then purified by column chromatography of neutral alumina, after the catalyst is removed, the solution was rotary evaporated, and then add the solution dropwise to the methanol solvent with stirring, finally the solution is extracted by Soxhlet extraction to obtain a purified polymer.

The following specific embodiments are provided for further illustrate of the polymer, the preparation method of the polymer and its applications.

### Example 1

The polymer is disclosed representing by the following formula: 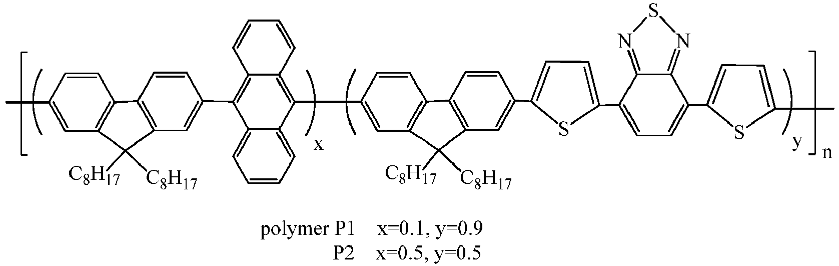 the preparation process of the polymer described above is as follows:
firstly, the preparation of 2, 7 - bis (4, 4, 5, 5 - tetramethyl-1, 3, 2 - dioxaborolan-2-yl) - 9, 9 - dioctylfluorene: 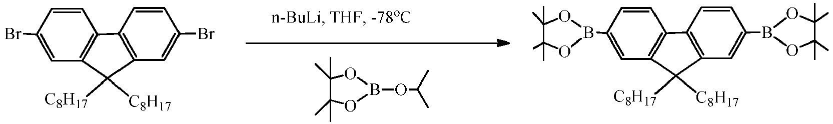 the anhydrous and oxygen-free reaction devices were assembled, 9.0mmol of white 2, 7 - dibromo - 9, 9 - dioctylfluorene was added to the 3-neck flask under continuous agitation and the protection of N₂, 150ml of purified tetrahydrofuran solvent was injected with a syringe, 27.0mmol of n-BuLi was injected slowly at -78°C with a syringe, and then the solution was stirred and reacted for 2 hours. After reacting for 2 hours, 30.6mmol of 2 - isopropoxy - 4, 4, 5, 5 - tetramethyl - 1, 3, 2 - dioxaborolane was injected with a syringe at -78°C, the temperature was raised to room temperature and the mixture reacted over night.

After the reaction was finished, saturated NaCl aqueous solution was added to the solution, and the solution was extracted by chloroform, dried by anhydrous sodium sulfate, pumping filtered, and then the filtrate was collected and the solvent was rotary evaporated off. Finally the raw product was subjected to silica gel column chromatography separation with petroleum ether: ethyl acetate (v / v = 15:1) as eluent to obtain the solid powder 2, 7 - bis (4, 4, 5, 5 - tetramethyl - 1, 3, 2 - dioxaborolan-2-yl) - 9, 9 - dioctylfluorene, the yield of the product was 65%. GC-MS (EI-m/z): 642 (M⁺).

Secondly, the preparation of the compounds with the following formulas

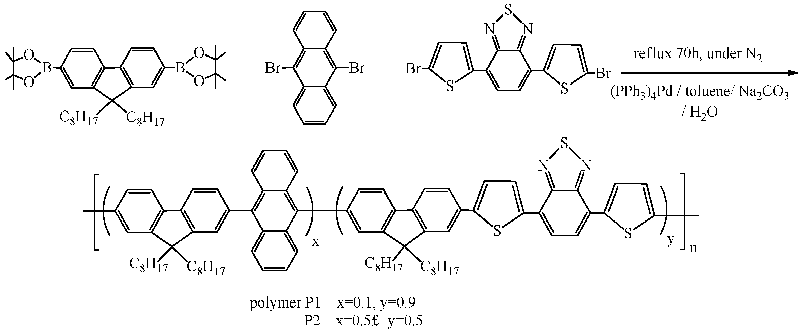

### The preparation of P1

1mmol of 2, 7 - bis (4, 4, 5, 5 - tetramethyl - 1, 3, 2 - dioxaborolan-2-yl) - 9, 9 - dioctylfluorene, 0.1mmol of 9, 10 - dibromoanthracene, 0.9mmol of 4, 7 - bis (5' - bromo - 2' - thienyl) -2, 1, 3 - benzothiadiazole, 0.025mmol of tetrakis (triphenylphosphine) palladium, 5ml of 2mol/L Na₂CO₃ aqueous solution and 30ml of toluene solvent were added to the reactor, the reaction system was kept in oxygen-free condition by purging N₂ and vacuum pumping repeatedly, at 90 °C, the reaction lasted for 70 hours.

After 70 hours, the deionized water and toluene were added to the reactor containing the product to extract the polymer, the organic phase was extracted, and the polymer/toluenewas was distilled to about 5ml under reduced pressure, and then added the organic phase dropwise to 300ml of anhydrous methanol with stirring constantly, and the solid was precipitated from the solution, the solid was pumping filtrated and dried to obtain the solid powder. And then the solid powder was dissolved in chloroform and purified by column chromatography of neutral alumina, after the catalyst tetrakis (triphenylphosphine) palladium was removed, the volume of the polymer/chloroform solution was reduced to about 5ml by rotary evaporation, the solution was added dropwise to the methanol solvent and stirred several hours, and then the polymer P1 was collected and dried. The polymer was extracted by Soxhlet extraction, sequentially the monodispersity of the polymer molecular weight of the polymer was improved.

The purified polymer P1 was subject to GPC measurement, the number average molecular weight Mn ≈ 52400, polymer monodisperse was 2.45.

### The preparation of P2

1mmol of 2, 7 - bis (4, 4, 5, 5 - tetramethyl - 1, 3, 2 -dioxaborolan-2-yl) - 9, 9 - dioctylfluorene, 0.5mmol of 9, 10 - dibromoanthracene and 0.5mmol of 4, 7 - bis (5'-bromo-2'-thienyl) -2, 1, 3 - benzothiadiazole were added to the reactor, the amount of other materials added, reaction conditions and post-treatment methods were similar to the preparation of P1, finally, the polymer P2 was obtained. The purified polymer P2 was subject to GPC measurement, the number average molecular weight Mn ≈ 41700, polymer monodisperse was 2.16.

### Example 2

The polymer is disclosed representing by the following formula: 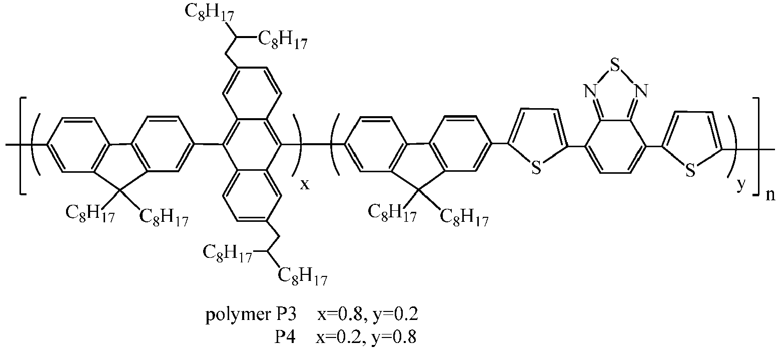 the preparation process of the polymer described above is as follows:
firstly, the preparation of 2,7 - bis (4, 4, 5, 5 - tetramethyl-1, 3, 2 - dioxaborolan-2-yl) - 9, 9 - dioctylfluorene: 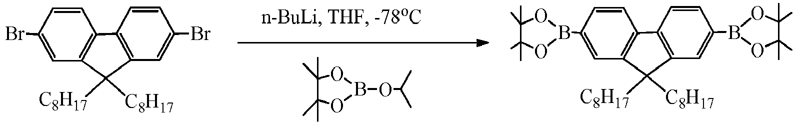 the anhydrous and oxygen-free reaction devices were assembled, 9.0mmol of white 2, 7 - dibromo - 9, 9 - dioctylfluorene was added to the 3-neck flask under continuous agitation and the protection of N₂, 150ml of purified tetrahydrofuran solvent was injected with a syringe, 27.0mmol of n-BuLi was injected slowly at -78°C with a syringe, and then the solution was stirred and reacted for 2 hours. After reacting for 2 hours, 30.6mmol of 2 - isopropoxy - 4, 4, 5, 5 - tetramethyl - 1, 3, 2 - dioxaborolane was injected with a syringe at -78 °C, the temperature was raised to room temperature and the mixture reacted over night.

After the reaction is finished, saturated NaCl aqueous solution was added, and the solution extracted by chloroform, dried by anhydrous sodium sulfate, pumping filtered, and then the filtrate was collected and the solvent was rotary evaporated off. Finally the raw product was subjected to silica gel column chromatography separation with petroleum ether: ethyl acetate (v / v = 15:1) as eluent to obtain the solid powder 2, 7 - bis (4, 4, 5, 5 - tetramethyl - 1, 3, 2 - dioxaborolan-2-yl) - 9, 9 - dioctylfluorene, the yield of the product was 65%. GC-MS (EI-m/z): 642 (M⁺).

Secondly, the preparation of the compounds with the following formulas.

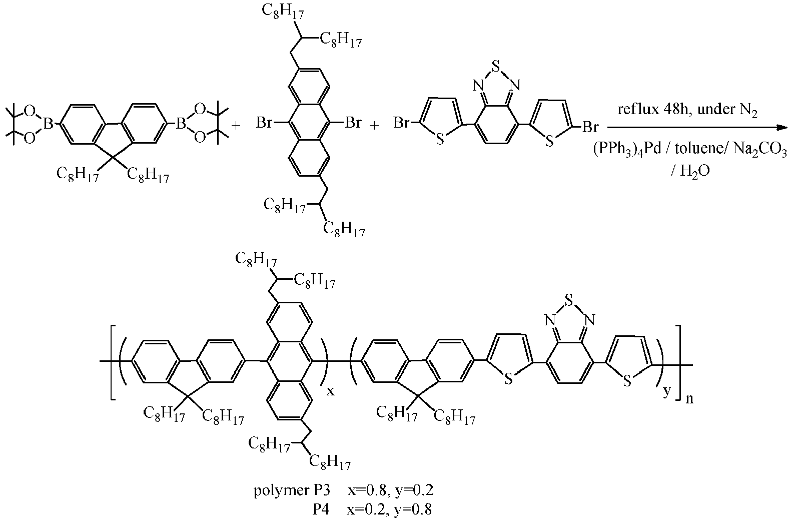

### The preparation of P3

1mmol of 2, 7 - bis (4, 4, 5, 5 - tetramethyl - 1, 3, 2 - dioxaborolan-2-yl) - 9, 9 - dioctylfluorene, 0.8mmol of 9, 10 - dibromo - 2, 6 - bis (2 - octyl decyl) anthracene (The preparation process of the compound can be referred by: Macromol. Chem. Phys.〉〉 Klaus Mullen etc., 2006, 207, 1107-1115), 0.2mmol of 4, 7 - bis (5' - bromo - 2' - thienyl) -2, 1, 3 - benzothiadiazole, 0.02mmol of tetrakis (triphenylphosphine) palladium, 10ml of 2mol/L Na₂CO₃ aqueous solution and 40ml of toluene solvent were added to the reactor, the reaction system was kept in oxygen-free condition by purging N₂ and vacuum pumping repeatedly. At 85 °C, the reaction lasted for 48 hours.

After 48 hours, the deionized water and toluene were added to the reactor to extract the polymer. The organic phase was extracted, and the polymer/toluene was distilled to a little under reduced pressure, and then added the organic phase dropwise to 300ml of anhydrous methanol with stirring constantly, and then the solid was precipitated from the solution, the solid was pumping filtrated and dried to obtain the solid powder. And then the solid powder was dissolved in chloroform and then purified by column chromatography of neutral alumina, after the catalyst tetrakis (triphenylphosphine) palladium was removed, the volume of the polymer/chloroform solution was reduced to about 5ml by rotary evaporation, the solution was added dropwise to the methanol solvent and stirred several hours, and then the polymer P3 was collected and dried. The polymer was extracted by Soxhlet extraction, sequentially the monodispersity of the polymer molecular weight of the polymer was improved.

The polymer purified P3 was subject to GPC measurement, the number average molecular weight Mn ≈ 35100, polymer monodisperse was 1.97.

### The preparation of P4

1mmol of 2, 7 - bis (4, 4, 5, 5 - tetramethyl - 1, 3, 2 - dioxaborolan-2-yl) - 9, 9 - dioctylfluorene, 0.2mmol of 9, 10 - dibromo - 2 ,6 - bis (2 - octyl decyl) anthracene and 0.8mmol of 4, 7 - bis (5' - bromo - 2' - thienyl) -2, 1, 3 - benzothiadiazole were added to the reactor, the amount of other materials added, reaction conditions and post-treatment methods were similar to the preparation of P3, finally, the polymer P4 was obtained. The purified polymer P4 was subject to GPC measurement, the number average molecular weight Mn ≈ 38600, polymer monodisperse was 1.88.

### Example 3

The polymer is disclosed representing by the following formula: 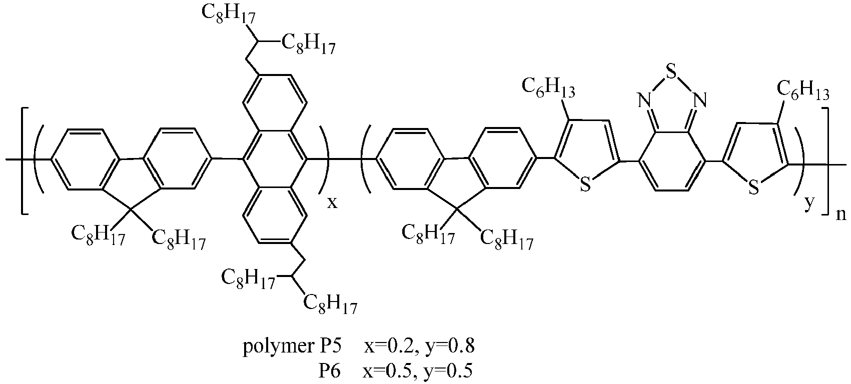 the preparation process of the polymer is as follows:
firstly, the preparation of 2, 7 - bis (4, 4, 5, 5 - tetramethyl - 1, 3, 2 - dioxaborolan-2-yl) - 9, 9 - dioctylfluorene: 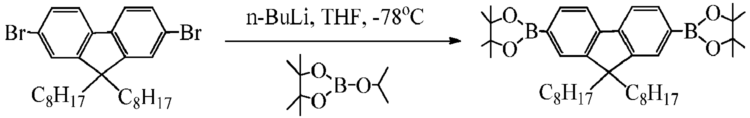 the anhydrous and oxygen-free reaction devices were assembled, 9.0mmol of white 2, 7 - dibromo - 9, 9 - dioctylfluorene was added to the 3-neck flask under continuous agitation and the protection of N₂, 150ml of purified tetrahydrofuran solvent was injected with a syringe, 27.0mmol of n-BuLi was injected slowly at -78°C with a syringe, and then the solution was stirred and reacted for 2 hours. After reacting for 2 hours, 30.6mmol of 2 - isopropoxy - 4, 4, 5, 5 - tetramethyl - 1, 3, 2 - dioxaborolane was injected with a syringe at -78 °C, the temperature was raised to room temperature and the mixture reacted over night.

After the reaction was finished, saturated NaCl aqueous solution was added to the solution, and the solution was extracted by chloroform, dried by anhydrous sodium sulfate, pumping filtered, and then the filtrate was collected and the solvent was rotary evaporated off. Finally the raw product was subjected to silica gel column chromatography separation with petroleum ether: ethyl acetate (v / v = 15:1) as eluent to obtain the solid powder 2, 7 - bis (4, 4, 5, 5 - tetramethyl - 1, 3, 2 - dioxaborolan-2-yl) - 9, 9 - dioctylfluorene, the yield of the product was 65%. GC-MS (EI-m/z): 642 (M⁺).

Secondly, the preparation of the compounds with the following formulas.

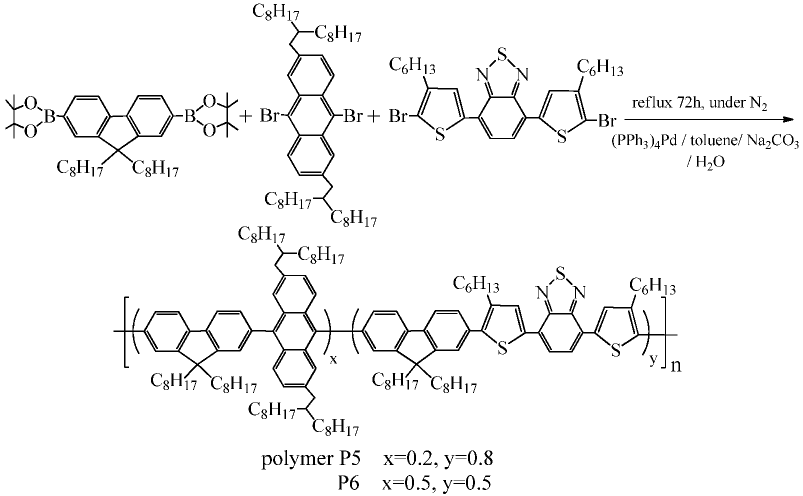

### The preparation of P5

1mmol of 2, 7 - bis (4, 4, 5, 5 - tetramethyl - 1, 3, 2 - dioxaborolan-2-yl) - 9, 9 - dioctylfluorene, 0.2mmol of 9, 10 - dibromo - 2, 6 - bis (2 - octyl decyl) anthracene, 0.8mmol of 4, 7 - bis (5' - bromo - 4' - hexyl - 2' - thienyl) - 2, 1, 3 - benzothiadiazole, 0.022mmol of tetrakis (triphenylphosphine) palladium, 10ml of 2mol/L Na₂CO₃ aqueous solution and 40ml of toluene solvent were added to the reactor, the reaction system was kept in oxygen-free condition by purging N₂ and vacuum pumping repeatedly, at 90 °C, the reaction lasted for 72 hours.

After 72 hours, the deionized water and toluene were added to the reactor containing the product to extract the polymer, the organic phase was extracted, and the polymer/toluene was distilled to about 5ml under reduced pressure, and then added the organic phase dropwise to 300ml of anhydrous methanol with stirring constantly, and the solid was precipitated from the solution, the solid was pumping filtrated and dried to obtain the solid powder. And then the solid powder was dissolved in chloroform and purified by column chromatography of neutral alumina, after the catalyst tetrakis (triphenylphosphine) palladium was removed, the volume of the polymer/chloroform solution was reduced to about 5ml by rotary evaporation, the solution was added dropwise to the methanol solvent and stirred several hours, and then the polymer P5 was collected and dried. The polymer was extracted by Soxhlet extraction, sequentially the monodispersity of the polymer molecular weight of the polymer was improved.

The purified polymer P5 was subject to GPC measurement, the number average molecular weight Mn ≈71400, polymer monodisperse was 2.65.

### The preparation of P6

1mmol of 2, 7 - bis (4, 4, 5, 5 - tetramethyl - 1, 3, 2 - dioxaborolan-2-yl) - 9, 9 - dioctylfluorene, 0.5mmol of 9, 10 - dibromo - 2, 6 - bis (2 - octyl decyl) anthracene and 0.5mmol of 4, 7 - bis (5' - bromo - 4' - hexyl - 2' - thienyl) -2, 1, 3 - benzothiadiazole were added to the reactor, the amount of other materials added, reaction conditions and post-treatment methods were similar to the preparation of P5, finally, the polymer P6 was obtained. The purified polymer P6 was subject to GPC measurement, the number average molecular weight Mn ≈ 65700, polymer monodisperse was 2.28.

### Example 4

The polymer is disclosed representing by the following formula: 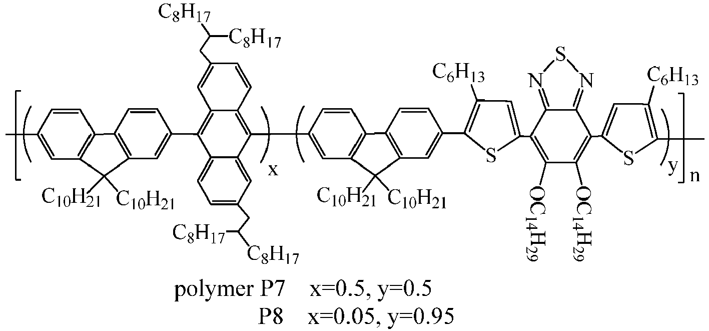 the preparation process of the polymer is as follows:
firstly, the preparation of 2, 7 - bis (4, 4, 5, 5 - tetramethyl - 1, 3, 2 - dioxaborolan-2-yl) - 9, 9 - didecylfluorene: 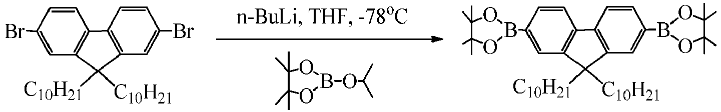 the anhydrous and oxygen-free reaction devices were assembled, 9.0mmol of white 2, 7 - dibromo - 9, 9 - didecylfluorene was added to the 3-neck flask under continuous agitation and the protection of N₂, 200ml of purified tetrahydrofuran solvent was injected with a syringe, 25.0mmol of n-BuLi was injected slowly at -78°C with a syringe, and then the solution was stirred and reacted for 2 hours.

After reacting for 2 hours, 28.0mmol of 2 - isopropoxy - 4, 4, 5, 5 - tetramethyl - 1, 3, 2 - dioxaborolane was injected with a syringe at -78 °C, the temperature was raised to room temperature and the mixture reacted over night.

After the reaction was finished, saturated NaCl aqueous solution was added to the solution, and the solution was extracted by chloroform, dried by anhydrous sodium sulfate, pumping filtered, and then the filtrate was collected and the solvent was rotary evaporated off. Finally the raw product was subjected to silica gel column chromatography separation with petroleum ether: ethyl acetate (v / v = 15:1) as eluent to obtain the solid powder 2, 7 - bis (4, 4, 5, 5 - tetramethyl - 1, 3, 2 - dioxaborolan-2-yl) - 9, 9 - didecylfluorene, the yield of the product was 71%. GC-MS (EI-m/z): 699 (M⁺).

Secondly, the preparation of 4, 7 - bis (5' - bromo - 4' - hexyl - 2' - thienyl) - 5, 6 - bis tetradecyloxy - 2, 1, 3 - benzothiadiazole:

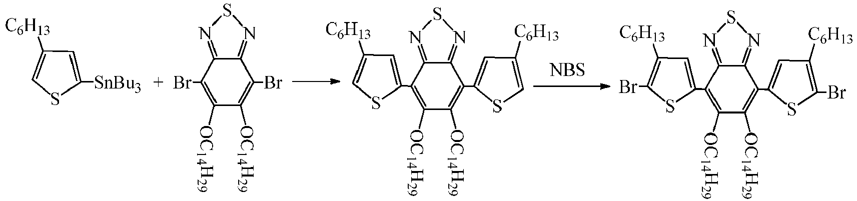

1mmol of 4, 7 - dibromo - 5, 6 - bis tetradecyloxy - 2, 1, 3 - benzothiopyrano oxadiazole and 2.2mmol of 4 - hexyl - 2 - tributyltin tin thiophene were dissolved in anhydrous toluene solvent, and then 0.03mmol of tetrakis (triphenylphosphine) palladium was added, the solution was refluxed and reacted over night under the protection of nitrogen. After the solution cooled down, the precipitation deposited in methanol solvent, 4, 7 - bis (4' - hexyl - 2' - thienyl) - 5, 6 - bis tetradecyloxy - 2, 1, 3 - benzothiadiazole was separated by silica gel column chromatography, the yield of the product was 68%. GC-MS (EI-m/z): 893 (M⁺).

1mmol of 4, 7 - bis (4' - hexyl - 2' - thienyl) -5, 6 - bis tetradecyloxy - 2, 1, 3 - benzothiadiazole and 2.3mmol of N - bromosuccinimide (NBS) were dissolved in 300ml chloroform solvent, the solution was added to the 2-neck flask that was protected by argon and stirred constantly, the reaction lasted for 50 hours in dark at room temperature. After the product was subjected to after-treatment, vacuum dried and silica gel column chromatography, the solid powder 4, 7 - bis (5' - bromo - 4' - hexyl - 2' - thienyl) -5, 6 - bis tetradecyloxy -2, 1, 3 - benzothiadiazole was obtained, the yield of the product was 72%. GC-MS (EI-m/z): 1051 (M⁺).

Thirdly, the preparation of the compounds with the following formulas.

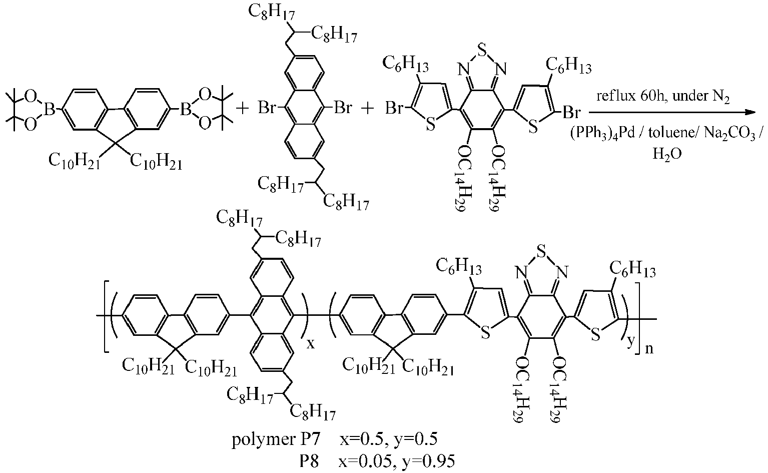

### The preparation of P7

1mmol of 2, 7 - bis (4, 4, 5, 5 - tetramethyl - 1, 3, 2 - dioxaborolan-2-yl) - 9, 9 - dioctylfluorene, 0.5mmol of 9, 10 - dibromo-2, 6 - bis (2 - octyl decyl) anthracene, 0.5mmol of 4, 7 - bis (5' - bromo - 4' - hexyl - 2' - thienyl) - 5, 6 - bis tetradecyloxy-2, 1, 3 - benzothiadiazole, 0.025mmol of tetrakis (triphenylphosphine) palladium, 10ml of 2mol/L Na₂CO₃ aqueous solution and 40ml of toluene solvent were added to the reactor, the reaction system was kept in oxygen-free condition by purging N₂ and vacuum pumping repeatedly, the reaction lasted for 60 hours at 88 °C.

After 60 hours, the deionized water and toluene were added to the reactor to extract the polymer, the organic phase was extracted, and the polymer/toluene was distilled to a little under reduced pressure, and then added the organic phase dropwise to 300ml of anhydrous methanol with stirring constantly, and the solid was precipitated from the solution, the solid was pumping filtrated and dried to obtain the solid powder. And then the solid powder was dissolved in chloroform and purified by column chromatography of neutral alumina, after the catalyst tetrakis (triphenylphosphine) palladium was removed, the volume of the polymer/chloroform solution was reduced to about 5ml by rotary evaporation, the solution was added dropwise to the methanol solvent and stirred several hours, and then the polymer P7 was collected and dried. The polymer was extracted by Soxhlet extraction, sequentially the monodispersity of the polymer molecular weight of the polymer was improved.

The purified polymer P7 was subject to GPC measurement, the number average molecular weight Mn ≈ 59800, polymer monodisperse was 2.57.

### The preparation of P8

1mmol of 2, 7 - bis (4, 4, 5, 5 - tetramethyl - 1, 3, 2 - dioxaborolan-2-yl) - 9, 9 - dioctylfluorene, 0.05mmol of 9, 10 - dibromo - 2 ,6 - bis (2 - octyl decyl) anthracene and 0.95mmol of 4, 7 - bis (5' - bromo - 4' - hexyl - 2' - thienyl) -5, 6 - bis tetradecyloxy - 2, 1, 3 - benzothiadiazole were added to the reactor, the amount of other materials added, reaction conditions and post-treatment methods were similar to the preparation of P7, the polymer P8 was obtained finally. The purified polymer P8 was subject to GPC measurement, the number average molecular weight Mn ≈ 61400, polymer monodisperse was 2.03.

The following specific embodiments were the applications of the polymer containing units of fluorene, anthracene and benzothiadiazole in the field of polymer solar cells, organic electroluminescent devices, organic field effect transistor, organic light storage, organic nonlinear material, organic laser material, and so on.

### Example 5

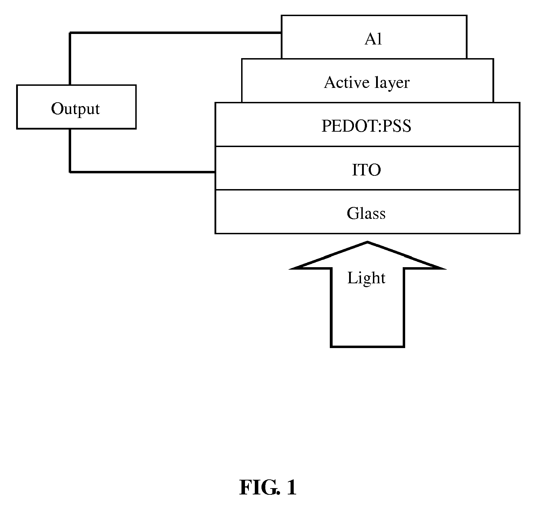

The structure of a kind of solar cell device was shown in FIG. 1. ITO glass (indium tin oxide glass) was used as substrate in the present embodiment, and ITO (indium tin oxide) was used as conductive layer. Polymer was the polymer P1 of the embodiment 1.

The structure of the solar cell device was as follows: glass/ITO/PEDOT: PSS/active layer/Al; wherein the material of the active layer was mixture which included [6, 6] - phenyl - C61 - butyric acid methyl ester as electron donor materials and the polymer containing units of fluorene, anthracene and benzothiadiazole as electron acceptor materials; ITO was indium tin oxide that the sheet resistance of the indium tin oxide was 10 to 20 Ω/□, PEDOT was poly 3, 4 - ethylenedioxy thiophene, PSS was polystyrene sulfonate.

The fabrication process of the solar cell device was as follows:
the ITO glass was ultrasonic cleaned and treated with an oxygen-Plasma, and then the PEDOT: PSS layer as modification was coated to the ITO surface;
the active layer was coated on the described PEDOT: PSS layer by spin coating technology, the materials of active layer included [6, 6] - phenyl - C61 - butyric acid methyl ester as electron donor materials and the polymer containing units of fluorene, anthracene and benzothiadiazole as electron acceptor materials;
metal aluminum was evaporated onto the surface of the described active layer under vacuum condition, the metal aluminum layer was formed as cathode, the described organic solar cell device was obtained. In this embodiment, the thickness of the metal aluminum layer was 170 nm, in other embodiments, the thickness of the metal aluminum layer might be 30 nm, 130 nm, 60 nm.

In this embodiment, the solar cell device was kept 4 hours in 110 degrees Celsius under sealed condition, and then cooled to room temperature, after the device annealed, the arranged order and tacticity within the groups and molecular chains of the molecule were effectively increased, the mobility and the rate of transmission speed of the carriers also increased, and then the photoelectric conversion efficiency of the solar cell device was improved.

### Example 6

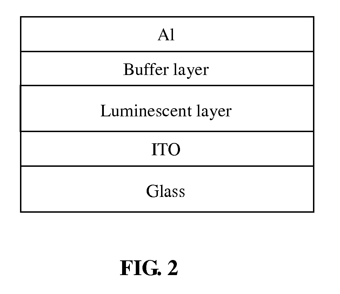

The structure of a kind of organic electroluminescent device was shown in FIG. 2. ITO glass (indium tin oxide glass) was used as substrate in the present embodiment, and ITO (indium tin oxide) was used as conductive layer, polymer was the polymer P1 of the embodiment 1.

The structure of the organic electroluminescent device was as follows: glass/ITO/luminescent layer/buffer layer/Al; wherein the material of the luminescent layer was the polymer containing units of fluorene, anthracene and benzothiadiazole; the material of the buffer layer was LiF; ITO was indium tin oxide that the sheet resistance of the indium tin oxide was 10-20 Ω/□, PEDOT was poly 3, 4 - ethylenedioxy thiophene, PSS was polystyrene sulfonate.

The fabrication process of the organic electroluminescent device was as follows:
the ITO glass was ultrasonic cleaned and treated with an oxygen-Plasma, and then the polymer containing units of fluorene, anthracene and benzothiadiazole was coated onto the ITO surface and formed as luminescent layer;
the LiF was evaporated onto the surface of the described luminescent layer and formed as buffer layer under vacuum condition;
metal aluminum was evaporated onto the surface of the described buffer layer under vacuum condition, the metal aluminum layer was formed as cathode, the organic electroluminescent device was obtained. In this embodiment, the thickness of the metal aluminum layer was 170 nm, in other embodiments, the thickness of the metal aluminum layer might be 30 nm, 130 nm, 60 nm.

### Example 7

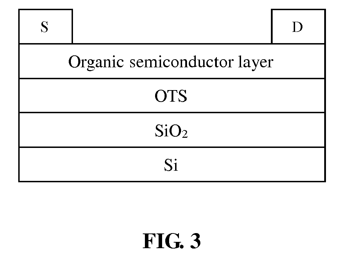

The structure of a kind of organic field-effect transistor was shown in FIG. 3. Highly doped silicon wafer was used as substrate in the present embodiment, polymer was the polymer P1 of the embodiment 1.

The structure of the organic field-effect transistor was as follows: Si/SiO₂/OTS/organic semiconductor layer/source electrode (S) and drain electrode (D); wherein the thickness of the SiO₂ with function of insulation was 500nm; OTS was octadecyltrichlorosilane; the material of the organic semiconductor layer was the polymer containing units of fluorene, anthracene and benzothiadiazole; the source electrode (S) and the drain electrode (D) were made of gold.

The fabrication process of the organic field-effect transistor was as follows: the doped silicon wafer substrate was cleaned, the SiO₂ layer with the function of insulation was deposited on the surface of the substrate;
the OTS was coated on the surface of the SiO₂ insulation layer and formed as OTS layer;
the polymer containing units of fluorene, anthracene and benzothiadiazole was coated onto the surface of the OTS layer and formed as organic semiconductor layer;

the gold source electrode and the gold drain electrode were disposed on the organic semiconductor layer, the organic field-effect transistor was obtained.

## Claims

1. A polymer containing units of fluorene, anthracene and benzothiadiazole, represented by the following formula: 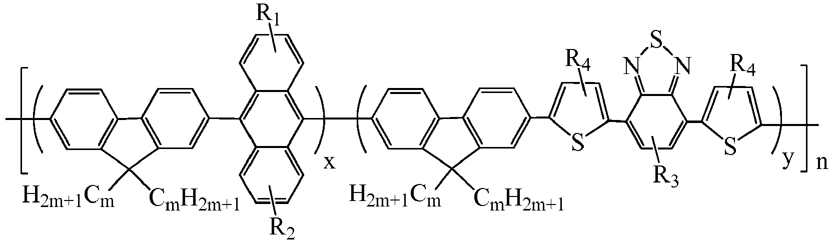
wherein n represents an integer between 1 and 200, m represents an integer between 1 and 20;
x, y are positive real numbers, and x + y = 1;
R₁, R₂ represent H, halogen, cyano, C₁ to C₄₀ alkyl, C₁ to C₄₀ aryl or C₁ to C₄₀ heteroaryl;
R₃, R₄ represent H, halogen, cyano, C₁ to C₄₀ alkyl, C₁ to C₄₀ alkoxy, C₆ to C₄₀ aryl, C₆ to C₄₀ aralkyl or C₆ to C₄₀ arylalkoxy.

2. A preparation method of the polymer according to claim 1, comprising the following steps:
S11, providing compounds A, B and C represented by the following formulas, respectively, 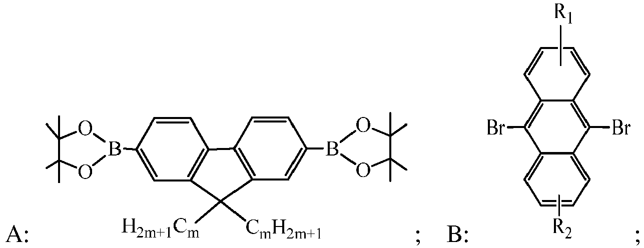 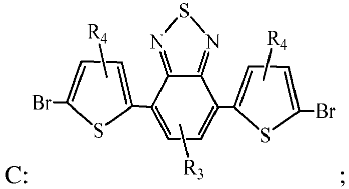 wherein m represents an integer between 1 and 20;
S12, subjecting compounds A, B and C to a Suzuki coupling reaction in the presence of organic solvent, catalyst and alkaline solution under the condition of oxygen-free environment to obtain the polymer containing units of fluorene, anthracene and benzothiadiazole with the following formula: 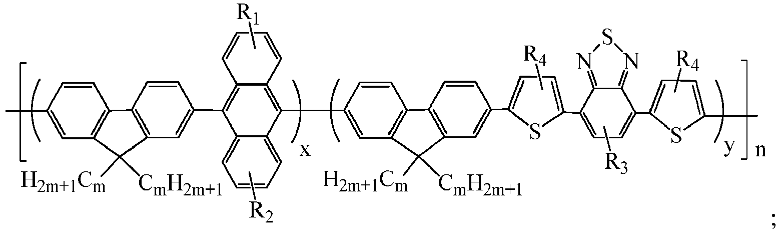
wherein n represents an integer between 1 and 200; m represents an integer between 1 and 20;
x, y are positive real numbers, and x + y = 1;
R₁, R₂ represent H, halogen, cyano, C₁ to C₄₀ alkyl, C₁ to C₄₀ aryl or C₁ to C₄₀ heteroaryl;
R₃, R₄ represent H, halogen, cyano, C₁ to C₄₀ alkyl, C₁ to C₄₀ alkoxy, C₆ to C₄₀ aryl, C₆ to C₄₀ aralkyl or C₆ to C₄₀ arylalkoxy.

3. The preparation method according to claim 2, wherein in step S11, the compound A is prepared by the following steps:
providing compounds D and E represented by the following formulas, respectively, 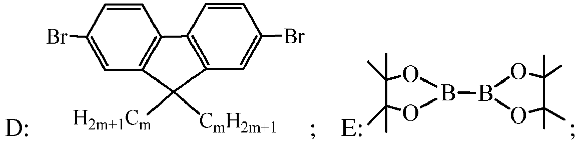 wherein m represents an integer between 1 and 20;
adding compound D to solvent under conditions of anhydrous and oxygen-free environment at a temperature of -70 °C to -85 °C, adding n-butyl lithium according to a molar ratio of the n-butyl lithium to the compound D of 2:1 to 4:1, stirring for 2 hours; the solvent is at least one selected from the group consisting of tetrahydrofuran, diethyl ether, dichloromethane, chloroform, and ethyl acetate;
adding compound E according to a molar ratio of the compound E to the compound D of 2:1 to 4:1, raising the temperature to room temperature, reacting for 12 to 48 hours to obtain compound A represented by the following formula: 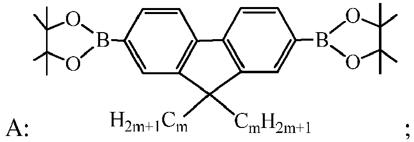 wherein m represents an integer between 1 and 20.

4. The preparation method according to claim 2, wherein in step S12, the solvent is at least one selected from the group consisting of toluene, ethylene glycol, dimethyl ether, tetrahydrofuran, diethyl ether, dichloromethane, chloroform and ethyl acetate; the added amount of the catalyst is 0.5% to 10% of a molar amount of the compound A;
the catalyst is organic palladium catalyst or a mixture of organic palladium and organic phosphine ligand;
the added amount of the alkali solution is 5 to 10 times of a molar amount of the compound A;
the alkali solution is NaOH aqueous solution, Na₂CO₃ aqueous solution, NaHCO₃ aqueous solution or tetraethyl ammonium hydroxide aqueous solution;
the temperature of the Suzuki coupling reaction is 60 to 100 °C, the reaction time is 12 to 72 hours.

5. The preparation method according to claim 4, wherein the molar ratio of the organic palladium to the organic phosphine ligand is 1:2 to 1:20 in the mixture of organic palladium and organic phosphine ligand.

6. The preparation method according to claim 4 or 5, wherein the organic palladium is Pd₂(dba)₃, Pd(PPh₃)₄ or Pd(PPh₃)₂Cl₂;
the organic phosphine ligand is P(o-Tol)₃.

7. The preparation method according to claim 2, further comprising: purifying the obtained polymer, wherein the purification steps comprise:
S13, adding deionized water and toluene to the polymer obtained in the step S12 to extract the polymer, extracting the organic phase, and distilling the organic phase under reduced pressure, and then adding the organic phase dropwise to the anhydrous methanol, stirring constantly, and then depositing the solid from the solution, after pumping filtrating and drying to obtain the solid powder, dissolving the solid powder in chloroform and then purifying by column chromatography of neutral alumina, after removing the catalyst and rotary evaporating the solution, and then adding dropwise to the methanol solvent and stirring, finally extracted by Soxhlet extraction to obtain a purified polymer.

8. A solar cell device made from the polymer according to claim 1, comprising a substrate, a conductive layer deposited on one surface of the substrate serving as an anode, a poly 3, 4 - ethylenedioxy thiophene: polystyrene sulfonate layer coated on the conductive layer functioning for modification, an active layer coated on the poly 3, 4 - ethylenedioxy thiophene: polystyrene sulfonate layer, and an aluminum layer disposed on the active layer serving as a cathode; the material of the active layer being mixture which comprises electron donor material and electron acceptor material; the electron acceptor material is [6,6]-phenyl-C61-butyric acid methyl ester, wherein the electron donor material comprises the polymer containing units of fluorene, anthracene and benzothiadiazole according to claim 1.

9. An organic electroluminescent device made from the polymer according to claim 1, comprising a substrate, a conductive layer deposited on one surface of the substrate serving as an anode, a luminescent layer coated on the conductive layer, a buffer layer with the material of LiF evaporated on the luminescent layer under vacuum condition, and an aluminum layer disposed on the buffer layer serving as a cathode, wherein the luminescent layer comprises the polymer containing units of fluorene, anthracene and benzothiadiazole according to claim 1.

10. An organic field-effect transistor made from the polymer according to claim 1, comprising a doped silicon wafer, a SiO₂ insulation layer, an octadecyltrichlorosilane layer with the function of modifying the SiO₂ insulation layer, an organic semiconductor layer coated on the octadecyltrichlorosilane layer, a source electrode and a drain electrode interval disposed on the organic semiconductor layer, which are laminated in this order, wherein the organic semiconductor layer comprises the polymer containing units of fluorene, anthracene and benzothiadiazole according to claim 1.

## Patentansprüche

1. Polymer mit Fluoren-, Anthracen- und Benzothiadiazol-Einheiten, das durch die folgende Formel wiedergegeben wird: 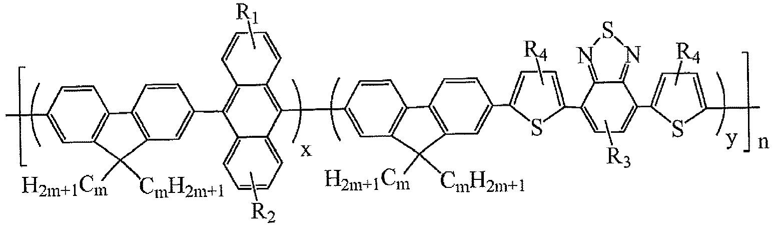
wobei n für eine ganze Zahl zwischen 1 und 200 steht, m für eine ganze Zahl zwischen 1 und 20 steht;
x, y positive reelle Zahlen sind und x + y = 1;
R₁, R₂ für H, Halogen, Cyano, C₁- bis C₄₀-Alkyl, C₁-bis C₄₀-Aryl oder C₁- bis C₄₀-Heteroaryl stehen;
R₃, R₄ für H, Halogen, Cyano, C₁- bis C₄₀-Alkyl, C₁-bis C₄₀-Alkoxy, C₆- bis C₄₀-Aryl, C₆- bis C₄₀-Aralkyl oder C₆- bis C₄₀-Arylalkoxy stehen.

2. Verfahren zur Herstellung des Polymers nach Anspruch 1, bei dem man:
S11, Verbindungen A, B und C bereitstellt, die durch die folgenden Formeln wiedergegeben werden, 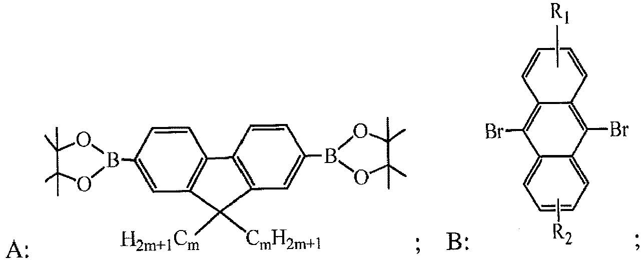 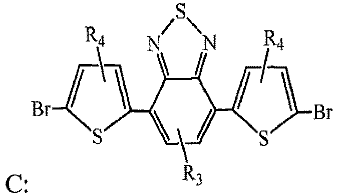 wobei m für eine ganze Zahl zwischen 1 und 20 steht;
S12, Verbindungen A, B und C einer Suzuki-Kupplungsreaktion in Gegenwart von organischem Lösungsmittel, Katalysator und alkalischer Lösung unter der Bedingung einer sauerstofffreien Umgebung unterwirft, wobei man das Polymer mit Fluoren-, Anthracen- und Benzothiadiazol-Einheiten mit der folgenden Formel erhält: 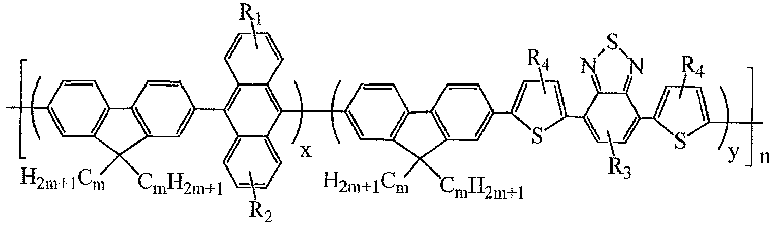
wobei n für eine ganze Zahl zwischen 1 und 200 steht, m für eine ganze Zahl zwischen 1 und 20 steht;
x, y positive reelle Zahlen sind und x + y = 1;
R₁, R₂ für H, Halogen, Cyano, C₁- bis C₄₀-Alkyl, C₁-bis C₄₀-Aryl oder C₁- bis C₄₀-Heteroaryl stehen;
R₃, R₄ für H, Halogen, Cyano, C₁- bis C₄₀-Alkyl, C₁-bis C₄₀-Alkoxy, C₆- bis C₄₀-Aryl, C₆- bis C₄₀-Aralkyl oder C₆- bis C₄₀-Arylalkoxy stehen.

3. Herstellungsverfahren nach Anspruch 2, bei dem in Schritt S11 die Verbindung A durch die folgenden Schritte hergestellt wird:
Bereitstellen von Verbindungen D und E, die durch die folgenden Formeln wiedergegeben werden: 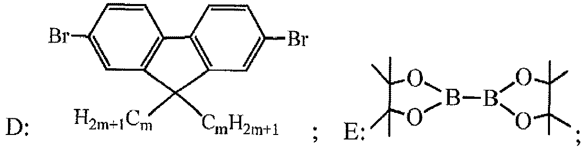
wobei m für eine ganze Zahl zwischen 1 und 20 steht;
Zugeben von Verbindung D zu Lösungsmittel unter Bedingungen einer wasser- und sauerstofffreien Umgebung bei einer Temperatur von -70°C bis -85°C, Zugeben von n-Butyllithium gemäß einem Molverhältnis von n-Butyllithium zu Verbindung D von 2:1 bis 4:1, 2 Stunden Rühren; wobei das Lösungsmittel mindestens eines aus der Gruppe bestehend aus Tetrahydrofuran, Diethylether, Dichlormethan, Chloroform und Essigsäureethylester ist;
Zugeben von Verbindung E gemäß einem Molverhältnis von Verbindung zu Verbindung D von 2:1 bis 4:1, Erhöhen der Temperatur auf Raumtemperatur, 12 bis 48 Stunden Umsetzen zum Erhalt von Verbindung A, die durch die folgende Formel wiedergegeben wird: 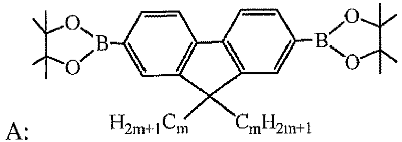 wobei m für eine ganze Zahl zwischen 1 und 20 steht.

4. Herstellungsverfahren nach Anspruch 2, bei dem in Schritt S12 das Lösungsmittel mindestens eines aus der Gruppe bestehend aus Toluol, Ethylenglykol, Dimethylether, Tetrahydrofuran, Diethylether, Dichlormethan, Chloroform und Essigsäureethylester ist;
die zugegebene Menge des Katalysators sich auf 0,5% bis 10% einer molaren Menge der Verbindung A beläuft;
es sich bei dem Katalysator um einen organischen Palladiumkatalysator oder eine Mischung von organischem Palladium und organischem Phosphinliganden handelt;
die zugegebene Menge der Alkalilösung sich auf das 5- bis 10-fache einer molaren Menge der Verbindung A beläuft;
es sich bei der Alkalilösung um wässrige NaOH-Lösung, wässrige Na₂CO₃-Lösung, wässrige NaHCO₃-Lösung oder wässrige Tetraethylammoniumhydroxidlösung handelt;
die Temperatur der Suzuki-Kupplungsreaktion 60 bis 100°C beträgt, die Reaktionszeit 12 bis 72 Stunden beträgt.

5. Herstellungsverfahren nach Anspruch 4, bei dem das molare Verhältnis von organischem Palladium zu organischem Phosphinliganden in der Mischung von organischem Palladium und organischem Phosphinliganden 1:2 bis 1:20 beträgt.

6. Herstellungsverfahren nach Anspruch 4 oder 5, bei dem es sich bei dem organischen Palladium um Pd₂ (dba)₃, Pd (PPh₃)₄ oder Pd (PPh₃)₂Cl₂ handelt;
es sich bei dem organischen Phosphinliganden um P(o-Tol)₃ handelt.

7. Herstellungsverfahren nach Anspruch 2, bei dem man ferner das erhaltene Polymer reinigt, wobei die Reinigungsschritte Folgendes umfassen:
S13, Zugeben von entionisiertem Wasser und Toluol zu dem in Schritt S12 erhaltenen Polymer zum Extrahieren des Polymers, Extrahieren der organischen Phase und Destillieren der organischen Phase unter vermindertem Druck und dann Zutropfen der organischen Phase zu wasserfreiem Methanol, konstantes Rühren und dann Abscheiden des Feststoffs aus der Lösung, nach Pumpen Filtrieren und Trocknen zum Erhalt des festen Pulvers, Lösen des festen Pulvers in Chloroform und dann Reinigen durch Säulenchromatographie an neutralem Aluminiumoxid, nach Entfernen des Katalysators und Einengen der Lösung am Rotationsverdampfer und dann Zutropfen zu dem Methanol-Lösungsmittel und Rühren, schließlich Extrahieren durch Soxhlet-Extraktion zum Erhalt eines gereinigten Polymers.

8. Aus dem Polymer nach Anspruch 1 hergestellte Solarzellenvorrichtung mit einem Substrat, einer auf einer Oberfläche des Substrats abgeschiedenen leitfähigen Schicht, die als Anode dient, einer auf der leitfähigen Schicht aufgetragenen Schicht aus Poly-3,4-ethylendioxythiophen:Polystyrolsulfonat, die zur Modifizierung dient, einer auf der Schicht aus Poly-3,4-ethylendioxythiophen:Polystyrolsulfonat aufgetragenen aktiven Schicht und einer auf der aktiven Schicht angeordneten Aluminiumschicht, die als Kathode dient; wobei es sich bei dem Material der aktiven Schicht um eine Mischung handelt, die Elektronendonormaterial und Elektronenakzeptormaterial umfasst; wobei es sich bei dem Elektronenakzeptormaterial um [6,6]-Phenyl-C61-buttersäuremethylester handelt, wobei das Elektronendonormaterial das Polymer mit Fluoren-, Anthracen- und Benzothiadiazol-Einheiten nach Anspruch 1 umfasst.

9. Aus dem Polymer nach Anspruch 1 hergestellte organische Elektrolumineszenzvorrichtung mit einem Substrat, einer auf eine Oberfläche des Substrats abgeschiedenen leitfähigen Schicht, die als Anode dient, einer auf der leitfähigen Schicht aufgetragenen Lumineszenzschicht, einer auf der Lumineszenzschicht unter Vakuumbedingungen aufgedampften Pufferschicht mit dem LiF-Material und einer auf der Pufferschicht angeordneten Aluminiumschicht, die als Kathode dient, wobei die Lumineszenzschicht das Polymer mit Fluoren-, Anthracen- und Benzothiadiazol-Einheiten nach Anspruch 1 umfasst.

10. Aus dem Polymer nach Anspruch 1 hergestellter organischer Feldeffekttransistor mit einem Wafer aus dotiertem Silicium, einer SiO₂-Isolationsschicht, einer Octadecyltrichlorsilanschicht mit der Funktion der Modifizierung der SiO₂-Isolationsschicht, einer auf die Octadecyltrichlorsilanschicht aufgetragenen organischen Halbleiterschicht, einer Source-Elektrode und einer Drain-Elektrode, die auf der organischen Halbleiterschicht beabstandet angeordnet sind, die in dieser Reihenfolge laminiert sind, wobei die organische Halbleiterschicht das Polymer mit Fluoren-, Anthracen- und Benzothiadiazol-Einheiten nach Anspruch 1 umfasst.

## Revendications

1. Polymère contenant des motifs de fluorène, d'anthracène et de benzothiadiazole, représenté par la formule suivants : 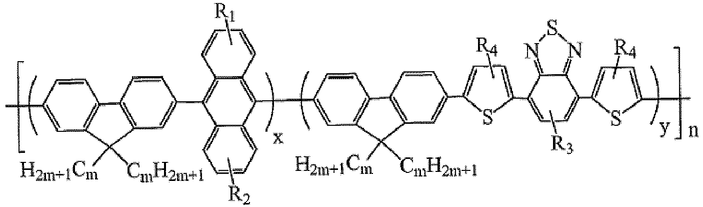
dans laquelle n représente un entier entre 1 et 200, m représente un entier entre 1 et 20 ;
x, y sont des nombres réels positifs, et x + y = 1 ;
R₁, R₂ représentent H, un halogène, un groupe cyano, un alkyle en C₁ à C₄₀, un aryle en C₁ à C₄₀ ou un hétéroaryle en C₁ à C₄₀ ;
R₃, R₄ représentent H, un halogène, un groupe cyano, un alkyle en C₁ à C₄₀, un alcoxy en C₁ à C₄₀, un aryle en C₆ à C₄₀, un aralkyle en C₆ à C₄₀ ou un arylalcoxy en C₆ à C₄₀.

2. Procédé de préparation du polymère selon la revendication 1, comprenant les étapes suivantes :
S11, se procurer des composés A, B et C respectivement représentés par les formules suivantes, 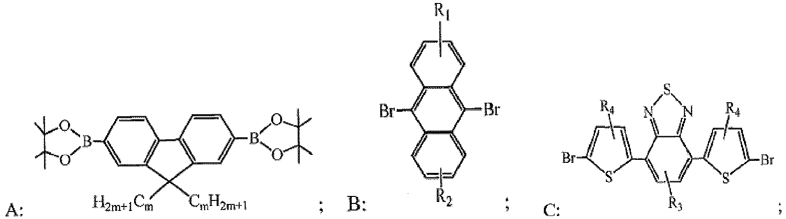 dans lesquelles m représente un entier entre 1 et 20 ;
S12, soumettre les composés A, B et C à une réaction de couplage de Suzuki en présence d'un solvant organique, d'un catalyseur et d'une solution alcaline dans les conditions d'un environnement dépourvu d'oxygène pour obtenir le polymère contenant des motifs de fluorène, d'anthracène et de benzothiadiazole avec la formule suivants : 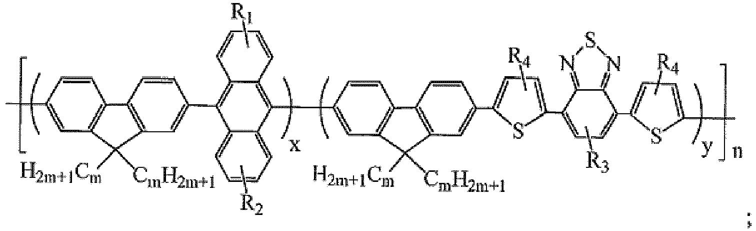
dans laquelle n représente un entier entre 1 et 200 ; m représente un entier entre 1 et 20 ;
x, y sont des nombres réels positifs, et x + y = 1 ;
R₁, R₂ représentent H, un halogène, un groupe cyano, un alkyle en C₁ à C₄₀, un aryle en C₁ à C₄₀ ou un hétéroaryle en C₁ à C₄₀ ;
R₃, R₄ représentent H, un halogène, un groupe cyano, un alkyle en C₁ à C₄₀, un alcoxy en C₁ à C₄₀, un aryle en C₆ à C₄₀, un aralkyle en C₆ à C₄₀ ou un arylalcoxy en C₆ à C₄₀.

3. Procédé de préparation selon la revendication 2 dans lequel, à l'étape S11, le composé A est préparé par les étapes suivantes :
se procurer des composés D et E respectivement représentés par les formules suivantes, 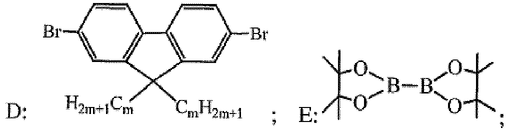 dans lesquelles m représente un entier entre 1 et 20 ; ajouter le composé D à un solvant dans des conditions d'environnement anhydre et dépourvu d'oxygène à une température de -70 °C à -85 °C, ajouter du n-butyllithium selon un rapport molaire entre le n-butyllithium et le composé D de 2:1 à 4:1, agiter pendant 2 heures ; le solvant étant au moins un solvant choisi dans le groupe constitué par le tétrahydrofurane, l'éther diéthylique, le dichlorométhane, le chloroforme et l'acétate d'éthyle ; ajouter le composé E selon un rapport molaire entre le composé E et le composé D de 2:1 à 4:1, élever la température jusqu'à la température ambiante, laisser réagir pendant 12 à 48 heures pour obtenir le composé A représenté par la formule suivante : 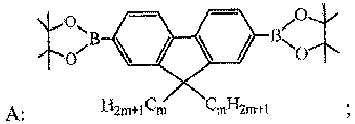 dans laquelle m représente un entier entre 1 et 20.

4. Procédé de préparation selon la revendication 2 dans lequel, à l'étape S12, le solvant est au moins un solvant choisi dans le groupe constitué par le toluène, l'éthylène glycol, l'éther diméthylique, le tétrahydrofurane, l'éther diéthylique, le dichlorométhane, le chloroforme et l'acétate d'éthyle ;
la quantité ajoutée du catalyseur représente 0,5 % à 10 % de la quantité molaire du composé A ;
le catalyseur est un catalyseur au palladium organique ou un mélange de palladium organique et de ligand phosphine organique ;
la quantité ajoutée de la solution alcaline représente 5 à 10 fois la quantité molaire du composé A ;
la solution alcaline est une solution aqueuse de NaOH, une solution aqueuse de Na₂CO₃, une solution aqueuse de NaHCO₃ ou une solution aqueuse d'hydroxyde de tétraéthylammonium ;
la température de la réaction de couplage de Suzuki est de 60 à 100 °C, le temps de réaction est de 12 à 72 heures.

5. Procédé de préparation selon la revendication 4, dans lequel le rapport molaire entre le palladium organique et le ligand phosphine organique est de 1:2 à 1:20 dans le mélange de palladium organique et de ligand phosphine organique.

6. Procédé de préparation selon la revendication 4 ou 5, dans lequel le palladium organique est Pd₂(dba)₃, Pd (PPh₃) ₄ ou Pd (PPh₃) ₂Cl₂ ;
le ligand phosphine organique est P(o-Tol)₃.

7. Procédé de préparation selon la revendication 2, comprenant en outre : la purification du polymère obtenu, les étapes de purification comprenant :
S13, ajouter de l'eau déminéralisée et du toluène au polymère obtenu à l'étape S12 pour extraire le polymère, extraire la phase organique, et distiller la phase organique sous pression réduite, puis ajouter goutte à goutte la phase organique au méthanol anhydre, agiter en continu, puis décanter le solide à partir de la solution, ensuite pomper, filtrer et sécher pour obtenir la poudre solide, dissoudre la poudre solide dans du chloroforme puis purifier par chromatographie sur colonne d'alumine neutre, ensuite retirer le catalyseur et évaporer la solution dans un évaporateur rotatif, puis ajouter goutte à goutte au solvant méthanol et agiter, finalement extraire par extraction Soxhlet pour obtenir un polymère purifié.

8. Dispositif de cellule solaire fabriqué à partir du polymère selon la revendication 1, comprenant un substrat, une couche conductrice déposée sur une surface du substrat servant d'anode, une couche de poly(3,4-éthylènedioxythiophène)-sulfonate de polystyrène déposée sur la couche conductrice avec une fonction de modification, une couche active déposée sur la couche de poly(3,4-éthylènedioxythiophène)-sulfonate de polystyrène, et une couche d'aluminium disposée sur la couche active servant de cathode ; le matériau de la couche active étant un mélange qui comprend un matériau donneur d'électrons et un matériau accepteur d'électrons ; le matériau accepteur d'électrons étant l'ester méthylique d'acide [6,6]-phényl-C61-butyrique ; le matériau donneur d'électrons comprenant le polymère contenant des motifs de fluorène, d'anthracène et de benzothiadiazole selon la revendication 1.

9. Dispositif électroluminescent organique fabriqué à partir du polymère selon la revendication 1, comprenant un substrat, une couche conductrice déposée sur une surface du substrat servant d'anode, une couche luminescente déposée sur la couche conductrice, une couche tampon avec le matériau LiF évaporée sur la couche luminescente sous vide, et une couche d'aluminium disposée sur la couche tampon servant de cathode, la couche luminescente comprenant le polymère contenant des motifs de fluorène, d'anthracène et de benzothiadiazole selon la revendication 1.

10. Transistor à effet de champ organique fabriqué à partir du polymère selon la revendication 1, comprenant une plaquette de silicium dopé, une couche d'isolation en SiO₂, une couche d'octadécyltrichlorosilane avec la fonction de modifier la couche d'isolation en SiO₂, une couche semi-conductrice organique déposée sur la couche d'octadécyltrichlorosilane, une électrode de source et une électrode de drain disposées par intervalle sur la couche semi-conductrice organique, qui sont appliquées dans cet ordre, la couche semi-conductrice organique comprenant le polymère contenant des motifs de fluorène, d'anthracène et de benzothiadiazole selon la revendication 1.
